Europäisches Patentamt

European Patent Office

Office européen des brevets

(19)

(11) Veröffentlichungsnummer : **0 025 523**
**B2**

(12) **NEUE EUROPÄISCHE PATENTSCHRIFT**

(45) Veröffentlichungstag der neuen Patentschrift :
06.05.87

(51) Int. Cl.⁴ : **H 01 L 41/04**

(21) Anmeldenummer : **80104950.3**

(22) Anmeldetag : **20.08.80**

(54) Piezoelektrische Messwandler.

(30) Priorität : 14.09.79 CH 8315/79

(43) Veröffentlichungstag der Anmeldung :
25.03.81 Patentblatt 81/12

(45) Bekanntmachung des Hinweises auf die Patenterteilung : 05.10.83 Patentblatt 83/40

(45) Bekanntmachung des Hinweises auf die Entscheidung über den Einspruch : 06.05.87 Patentblatt 87/19

(84) Benannte Vertragsstaaten :
AT DE FR GB

(56) Entgegenhaltungen :
US-A- 3 437 851
JEE JOURNAL OF ELECTRONIC ENGINEERING, Nr. 127, Juli 1977, Tokyo, JP, H. NONAKA: "SAW filters play effective role for high frequencies", Seiten 58-61 Elastic und Piezoelectric Characteristics of Bismuth Germanium Oxide Bi12Ge020"; in: IEEE TRANSACTIONS ON SONICS AND ULTRASONICS, vol. SU-14, no. 4, Oktober 1967, Verf.: ONOE, WARNER, BALLMAN, Seiten 165-167
"Piezoelectricity"; McGraw Hill, New York, 1946, 1. Ausgabe, Verfasser: W.C. CADY, Seiten 19,20 und 201-204
"Dana's System of Mineralogy", vol. III, v. C. Frondel, Wiley, 1962, New York und London, S. 9
J. Appl. Phys., vol. 43, no. 1, (1972), S. 247-248 "Elastic, Piezoelectric and Dielectric Constants of Bi12Ge020"
"Brockhaus der Naturwissenschaften u. der Technik", 1971, S. 435
"Einführung in die Kristallographie", v. Will Kleber, 10. Auflage (1969), VEB Verlag Technik, Berlin, S. 82-83

(73) Patentinhaber : Kistler Instrumente AG
Eulachstrasse 22
CH-8408 Winterthur (CH)

(72) Erfinder : Calderara, Reto
Schaffhauserstrasse 51
CH-8400 Winterthur (CH)

(74) Vertreter : Schmidt, Horst, Dr. et al
Patentanwälte Pohlmann & Schmidt Siegfriedstrasse 8
D-8000 München 40 (DE)

Jouve, 18, rue St-Denis, 75001 Paris, France

## Beschreibung

Die Erfindung betrifft piezoelektrische Kraft-, Druck- und Beschleunigungsmesswandler, bestehend aus einem kubisch-polaren Einkristall.

Bei der Analyse von dynamischen Kraft- und Druckverläufen, Beschleunigungen und Vibrationszuständen wird sehr oft von der piezoelektrischen Messtechnik Gebrauch gemacht, da sich diese Methode durch grosse Präzision und Universalität in den Anwendungsmöglichkeiten auszeichnet. Piezoelektrische Messwandler zeichnen sich gegenüber anderen Systemen durch extreme Starrheit, kleine Dimensionen und sehr hohe Eigenfrequenzen aus. Dies ermöglicht praktisch translationsfreie Messungen mit minimaler Rückwirkung auf das Messobjekt sowie die simultane Auflösung mehrerer Vektorkomponenten. Einmalig ist die Möglichkeit, bei Druck-, Kraft-, Schub- und Drehmomentmessungen statische Vorlasten, die um mehrere Zehnerpotenzen grösser als der Messwert sein können, ohne Präzisionsverlust elektrisch zu kompensieren.

Die Entwicklung der Messtechnik verlangt in zunehmendem Masse nach hochempfindlichen miniaturisierten Messwandlern. Nun führt aber die Verkleinerung eines Messwandlers grundsätzlich zu einer Verringerung dessen Empfindlichkeit. Dieses Dilemma hat den Trend verstärkt, piezoelektrische Messwertaufnehmer mit integrierten Impedanzwandler-Vorverstärkern zu versehen. Solche Verstärker sind auch anwendungstechnisch vorteilhaft, da sie die Verwendung extrem hochisolierender Signalübertragungsleitungen, wie sie bei der herkömmlichen Ladungsverstärkung notwendig sind, erübrigen.

Der Eingang dieser integrierten Vorverstärker ist allgemein mit einem Feldeffekt-Transistor bestückt. Dies bedeutet, dass zum Erreichen eines guten Signal- zu Rauschverhältnisses am Vorverstärkereingang eine möglichst hohe elektrische Spannung pro mechanische Messeinheit anzustreben ist. Hiezu genügt es nicht, für die aktiven Aufnehmerelemente ein piezoelektrisches Material mit maximalem Feldstärkekoeffizienten $g_m$, zu wählen, denn in einem Messwandler wird die Spannungsempfindlichkeit reduziert durch die Gatekapazität C, des Feldeffekttransistors und durch die Shuntkapazität C zwischen den spannungsführenden Leitern vom Piezoelektrikum zum Gate- und sämtlichen übrigen Konstruktionselementen des Messwandlers auf Gegenpotential. Die Spannungsempfindlichkeit S eines Aufnehmers kann dargestellt werden durch

$$S_v = \frac{f_1 \cdot d_{m\mu}}{\varepsilon_Q \cdot \varepsilon_{mm} \cdot f_2 + C_g + C_s(f_3)}$$

worin

$d_{m\mu}$ : Piezoelektrischer Ladungskoeffizient des aktiven Materials

$\varepsilon_o$ : Influenzkonstante

$\varepsilon_{mm}$ : Dielektrizitätskonstante des aktiven Materials

$f_{123}$ : Faktoren, die von der Geometrie der Krafteinleitenden bzw. der aktiven bzw. der kapazitätsbestimmenden Elemente abhängen.

Diese Formel erklärt das grundsätzliche Problem des Empfindlichkeitsverlustes bei miniaturisierten piezoelektrischen Messaufnehmern mit spannungsverstärkenden Impedanzwandlern.

Bei Verkleinerung der geometrischen Abmessungen eines Aufnehmers bleibt die Gatekapazität C konstant und die Shuntkapazitäten C bis zum Verstärkereingang nehmen nur unterproportional ab. Das heisst, der kapazitive Nebenschluss bekommt Uebergewicht, relativ zur Kapazität des Piezoelektrikums und wird dadurch zum limitierenden Faktor. Aus der Formel wird deutlich, dass von piezoelektrischen Messwandlermaterialien sowohl hohe Dielektrizitätskonstanten als auch Piezokoeffizienten gefordert werden müssen, und dass diese Daten die technisch sinnvollen Abmessungen und Einsatzmöglichkeiten für jedes Piezoelektrikum verschieden eingrenzen.

Die aktiven Elemente piezoelektrischer Präzisionsmesszellen bestehen besonders häufig aus Quarzkristall, denn dieses Material ist durch die ausgezeichnete Linearität und Konstanz seiner elektrischen und mechanischen Eigenschaften zu solchen Anwendungen geradezu prädestiniert. Quarz besitzt zwar einen hohen piezoelektrischen Feldstärkekoeffizienten $g_{11}$, doch schränken die relativ ungünstigen Daten für $d_{11}$ und $\varepsilon_{11}$ die Anwendungen in Miniaturaufnehmern sehr stark ein.

Als Alternativen stehen mehrere ditrigonal-pyramidale Kristalle wie z. B. Lithiumniobat, Lithiumtantalat und Turmalin zur Verfügung. Kristalle dieser Symmetrie sind pyroelektrisch. Da sie noch weitere schwerwiegende Nachteile wie stark anisotrope thermische Ausdehnung, ungenügende elektrische Isolation bei höheren Temperaturen, bzw. kleine piezoelektrische Empfindlichkeit aufweisen, können sie Quarz nur in Spezialfällen ersetzen.

Eine andere Gruppe von piezoelektrischen Wandlermaterialien umfasst die zahlreichen ferroelektrischen Keramiken, die definitionsgemäss alle auch pyroelektrisch sind. In dieser Materialgruppe wird der Vorteil der teils recht grossen piezoelektrischen Longitudinalempfindlichkeit oft schon zunichte gemacht durch die damit parallel gehende Pyroelektrizität. Beim piezoelektrischen Transversaleffekt sind die Verhältnisse noch ungünstiger. Ein besonders schwerwiegender Nachteil ferroelektrischer Keramiken liegt in Zeitabhängigkeit und Nichtlinearität ihrer Eigenschaften, was ihre Anwendung ausschliesst, wo hohe Anforderungen an die Messpräzision gestellt werden.

Die Entwicklung der Piezomesstechnik verlangt somit nach neuen Kristallen, die gute piezoelektrische und dielektrische Materialdaten aufweisen, ohne aber an den genannten Nachteilen zu leiden.

Das erste Auswahlkriterium für die gesuchte neue Gruppe von piezoelektrischen Materialien sei das Fehlen von Pyroelektrizität. Dies schliesst bereits die zehn kristallographischen Symmetrieklassen mit singulären polaren Achsen aus.

Es können noch weitere Kriterien durch die Kristallsymmetrie definiert werden. Eine möglichst hohe Symmetrie ist wünschenswert im Hinblick auf Isotropie der Festigkeits- und Ausdehnungseigenschaften. Die Symmetrie darf aber nicht so hoch sein, dass die Piezoelektrizität verschwindet, was namentlich schon bei Vorliegen eines Inversionszentrums der Fall ist. Andererseits darf die Kristallsymmetrie auch nicht zu niedrig sein, denn sonst werden zuviele Matrixelemente des Piezoelektrizitätstensors von Null verschieden, was Störeffekte wie Einspann- und Seitenempfindlichkeiten verursacht. Von Präzisionsmesswandlern wird verlangt, dass ihre Empfindlichkeit in einer exakt spezifizierten Krafteinleitungsrichtung liegt. Beispielsweise darf ein Scherkraftaufnehmer nicht auf Longitudinalkräfte (Einspanndruck) ansprechen und umgekehrt.

In piezoelektrischen Messwandlern für mechanische Grössen werden Kristalle und Keramiken verwendet, deren Piezoelektrizitätstensoren endliche Matrixelemente für Longitudinal-, Transversal- und orthoaxiale Schereffekte besitzen. Diese drei Belastungsfälle werden technisch durch unzählige Aufnehmerkonstruktionen verwirklicht. Es gibt nun auch Kristalle, deren Symmetrie in der Matrixdarstellung der Piezoelektrizitätstensoren ausschliesslich synaxiale Scherkoeffizienten auftreten lässt. Da sich der synaxiale Schermodus mit den konventionellen Messwandlerkonstruktionen nicht dazu eignet, mittels des direkten Piezoeffektes mechanische Signale in elektrische umzuformen, sind derartige Kristalle bisher als ungeeignet für die Piezomesstechnik angesehen worden.

Das Ziel der vorliegenden Erfindung ist mithin. Wege aufzuzeigen, wie neuartige piezoelektrische Messwandlerelemente hergestellt werden können, aus Kristallen mit ausschliesslich synaxialen Scherpiezokoeffizienten, derart, dass ihre Anwendung im Transveral- und im orthoaxialen Schermodus ermöglicht wird.

Der Gedankengang, der dieser Erfindung zugrundeliegt, ist kurz zusammengefasst, der folgende : Die allgemeine Zustandsgleichung für den direkten piezoelektrischen Effekt lautet bekanntlich :

$$D_m = \sum_{\mu = 1}^{6} (d_{m\mu} \cdot T_\mu) + \sum_{n = 1}^{3} (\varepsilon_{mn}^T \cdot E_n)$$

Hierin bedeuten :
D : die dielektrischen Verschiebungen (Ladung pro Fläche)
d : die piezoelektrischen Koeffizienten
T : die mechanischen Spannungen (Kraft pro Fläche)
$\varepsilon$ : die Dielektrizitätskonstanten
E : die elektrischen Feldstärken

Die Indizes m (bzw. n) bezeichnen die Richtungskomponenten der dielektrischen Verschiebung (bzw. Feldstärke), bezogen auf orthogonale Kristallkoordinaten und laufen von 1 bis 3, entsprechend den Achsen X, Y, Z. Analog werden mit den reduzierten Indizes $\mu$ die Komponenten des elastischen Spannungstensors bezeichnet. Wie üblich bedeuten $T_1$, $T_2$, $T_3$ Spannungen parallel zu und $T_4$, $T_5$, $T_6$ Scherspannungen um die Achsen X, Y, Z.

Die piezoelektrischen Koeffizienten $d_{m\mu}$ bilden also einen Tensor dritter Ordnung, der im allgemeinen Falle durch 18 Matrixelemente darzustellen ist.

Die Elemente mit m = $\mu$ stellen die drei Longitudinaleffekte dar, die drei mit m = ($\mu$ — 3) werden als synaxiale Schereffekte bezeichnet. Unter den übrigen Matrixelementen mit m $\neq$ $\mu$ sind die sechs mit $\mu \leq 3$ den transversalen Piezoeffekten und die sechs Element mit $\mu > 3$ den orthoaxialen Schereffekten zugeordnet.

Bei den hier bevorzugten Anwendungen ist der Beitrag des Feldstärkevektors zur dielektrischen Verschiebung praktisch vernachlässigbar klein gegenüber dem Einfluss des elastischen Spannungstensors. Deshalb wird im Folgenden nur noch der letztere berücksichtigt. Damit lautet die obige Beziehung für den direkten Piezoeffekt eines Materials mit ausschliesslich synaxialen Schereffekten in Matrixdarstellung allgemein :

$$\begin{pmatrix} D_1 \\ D_2 \\ D_3 \end{pmatrix} = \begin{pmatrix} 0 & d_{14} & 0 & 0 \\ 0 & 0 & d_{25} & 0 \\ 0 & 0 & 0 & d_{36} \end{pmatrix} \times \begin{pmatrix} T_1 \\ T_2 \\ T_3 \\ T_4 \\ T_5 \\ T_6 \end{pmatrix}$$

Diese Voraussetzungen sind bei sechs kristallographischen Symmetrieklassen verwirklicht. Kommen weitere Symmetrielemente zu jenen der orthorhombischdisphenoidischen Kristallklasse hinzu, so gelten folgende Beziehungen zwischen den Koeffizienten : In der tetragonal-skalenoedischen Kristallklasse : $(d_{25} = d_{14})$ ; bei tetragonal- und hexagonal-trapezoedischen Kristallen $(d_{25} = - d_{14} ; d_{36} = 0)$. Bei der kubisch-hexakistetraedischen und der tetraedisch-pentagondodekaedischen Kristallklasse schliesslich gilt : $(d_{14} = d_{25} = d_{36})$.

Diese beiden Klassen werden zusammenfassend als Kubisch-Polare bezeichnet und sollen im Folgenden speziell behandelt werden. Alle Berechnungen können aber sinngemäss analog auch für die genannten Kristallklassen niedrigerer Symmetrie durchgeführt werden.

Es gibt in der Natur viele Mineralien, welche den kubisch-polaren Kristallklassen angehören. Als Beispiele seien Zinkblende ZnS bzw. Gersdorffit NiAsS angeführt.

Es sind auch sehr viele synthetische Kristalle dieser Symmetrieklassen hergestellt worden, darunter auch einige mit beachtlich starker Piezoelektrizität. Als Beispiele seien genannt : Cadmiumsulfid CdS und Zinkselenid ZnSe ; sowie Natrium-chlorat $NaClO_3$ und Wismutgermaniumoxid $Bi_{12}GeO_{20}$.

Die letztgenannte Substanz weist recht hohe Materialwerte sowohl bezüglich der piezoelektrischen und dielektrischen Daten, als auch hinsichtlich thermischen und elastischen Eigenschaften auf, wodurch sie für die Piezomesstechnik potentiell interessant wird.

Dank seiner piezoelektrischen Eigenschaften hat Wismutgermaniumoxid ebenso wie andere kubisch-polare Kristalle bereits technische Anwendungen gefunden, namentlich als Resonator in der Ultraschalltechnik, als elektrooptischer Modulator und in Verzögerungselementen, wo die relativ niedrige Schallgeschwindigkeit und der günstige elektromechanische Kopplungsfaktor von Nutzen sind. Auf dieser Basis wurden sogar schon Konstruktionen vorgeschlagen, welche die indirekte Messung von Drücken, Kräften oder Beschleunigungen ermöglichen (z. B. US Patent 3 863 497 (Van de Vaart et al.). Dabei wird durch das zu messende mechanische Signal ein Kristallstab verbogen, auf dessen Oberfläche durch Anschluss an einen Wechselspannungsgenerator eine Rayleighschwingung angeregt wird. Nach Massgabe der Verbiegung wird die Wellenausbreitung verändert, wodurch die Messgrösse indirekt in Form einer Phasenverschiebung detektiert werden kann.

Allen diesen Anwendungen ist gemeinsam, dass ein achsenparallel aus dem Kristall geschnittenes Resonatorelement durch Zufuhr von elektrischer Energie zu Schwingungen auf einer seiner Eigenfrequenzen angeregt wird. Die Wirksamkeit hängt dabei vom elektromechanischen Kopplungsfaktor ab, wogegen die piezoelektrischen Koeffizienten nur untergeordnete Bedeutung haben als Antriebskonstanten. Solche Kristallelemente sind piezoelektrisch inaktiv gegenüber longitudinaler, transversaler und orthoaxialer Belastung.

Hievon unterscheiden sich die Messwandlerelemente, welche den Gegenstand der vorliegenden Erfindung bilden, ganz fundamental, indem ihnen keine elektrische Energie zugeführt wird, sondern die zu messende mechanische Kraftgrösse mittels des direkten Piezoeffektes in ein proportionales elektrisches Signal umgeformt wird. Ausserdem arbeiten diese Messwandlerelemente auch nicht auf ihren Resonanzfrequenzen, im Gegenteil, es werden sogar konstruktive Massnahmen getroffen, um Eigenschwingungen möglichst weitgehend zu eliminieren.

Um nun kubisch-polare Kristalle in Messwandlern anwenden zu können, die auf dem direkten Piezoeffekt basieren, ist es notwendig, daraus Kristallelemente herzustellen, welche auch bei transversaler bzw. antiaxialer Scher-Belastung piezoelektrisch aktiv sind. Wie dies möglich ist, kann gezeigt werden, indem man die tensorielle Richtungsabhängigkeit in den Zustandsgleichungen für den direkten Piezoeffekt in Rechnung zieht.

Zur Herleitung der piezoelektrischen Koeffizienten für eine beliebige Raumrichtung ist es zweckmässig, die Lage des Kristallelementes zu den Koordinatenachsen nach Gauss durch sukzessive Rotationen um aufeinander senkrecht stehende Achsen zu beschreiben.

Die Transversal- und Scherkoeffizienten können dann als Funktionen der Orientierungswinkel $\alpha$, $\beta$, $\gamma$ berechnet werden, aus der nichtreduzierten d-Matrix (allgemein 27 Elemente mit dreistelligen Indizes), indem man für jede der Rotationen die Symmetrieoperatoren des Kristallelementes anwendet und mit den bekannten Transformationsmatrizen multipliziert und schliesslich wieder auf zweistellige Indizes übergeht.

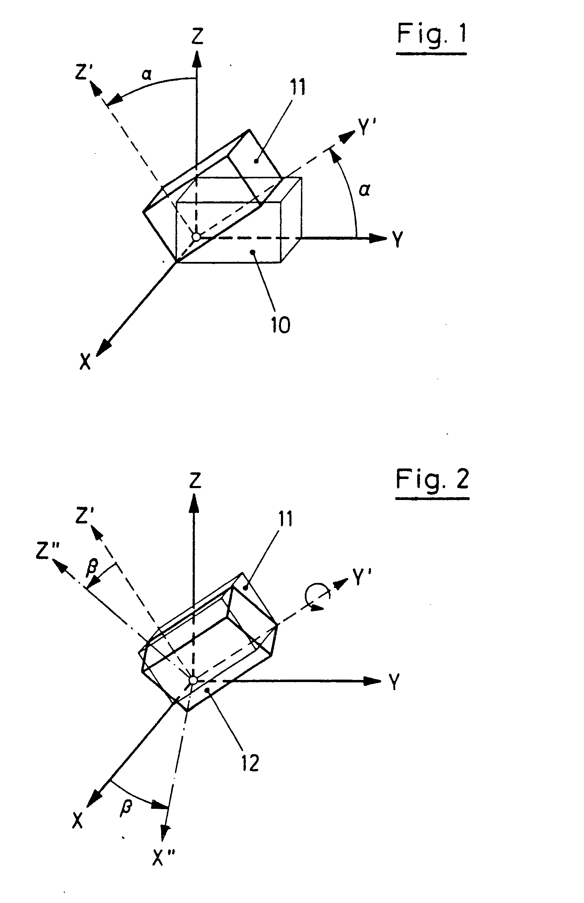

Figur 1 erläutert die Bezeichnungen bei der ersten Rotation. Kristallelement (10) ist parallel zu den kristallographischen Achsen X, Y, Z geschnitten und ist somit piezoelektrisch inaktiv gegenüber transversalen und orthoaxialen Normalkräften. Kristallelement (11) ist bezüglich des X-Achse um den Orientierungswinkel $\alpha > 0$ gedreht. Seine Kantenrichtungen bzw. transformierten Achsen Y' und Z' fallen allgemein nicht mehr mit kristallographischen Symmetrieelementen zusammen. Diese Zuordnungen gelten sinngemäss auch für anders geformte, beispielsweise kreisscheibenförmige Messwandlerelemente, die schief zu den Hauptachsen X, Y, Z aus einem Kristall geschnitten sind.

Man erhält so die folgenden Ausdrücke für die Orientierungsabhängigkeit der piezoelektrischen Koeffizienten :

$d'_{11} = 0$

$d'_{12} = d_{14} \cdot \cos \alpha \cdot \sin \alpha$

$d'_{13} = - d_{14} \cdot \cos \alpha \cdot \sin \alpha$

$d'_{14} = d_{14}(\cos^2 \alpha - \sin^2 \alpha)$

$d'_{15} = d'_{16} = d'_{21} = d'_{22} = d'_{23} = d'_{24} = 0$

$$d'_{25} = d_{25} \cdot \cos^2 \alpha - d_{36} \cdot \sin^2 \alpha$$
$$d'_{26} = (d_{25} + d_{36}) \cdot \cos \alpha \cdot \sin \alpha$$
$$d'_{31} = d'_{32} = d'_{33} = d'_{34} = 0$$
$$d'_{35} = -(d_{25} + d_{35}) \cos \alpha \cdot \sin \alpha$$
$$d'_{36} = d_{36} \cdot \cos^2 \alpha - d_{25} \cdot \sin^2 \alpha$$

Durch eine einachsige Rotation erhält man somit Kristallelemente, die sowohl transversalen Piezoeffekt wie auch antiaxialen Scherpiezoeffekt aufweisen. Man erkennt leicht, dass bei kubischpolaren Kristallen maximale Empfindlichkeiten bei einem Orientierungswinkel $\alpha = 45°$ erzielt werden, und dass dann die synaxialen Schereffekte verschwinden. Die d' — Matrix erhält somit für einen kubischpolaren X + 45° — Kristall folgende Form :

$$d'_{m\mu} = \begin{pmatrix} 0 & \dfrac{d_{14}}{2} & \dfrac{-d_{14}}{2} & 0 & 0 & 0 \\ 0 & 0 & 0 & 0 & 0 & d_{14} \\ 0 & 0 & 0 & 0 & -d_{14} & 0 \end{pmatrix}$$

Hieraus ist ohne weiteres ersichtlich, dass im orthoaxialen Schermodus keine Störung durch Transversalempfindlichkeit auftritt und umgekehrt, da bei $\alpha = 45°$ die Krafteinleitungsflächen in kristallographischen Diagonalebenen verlaufen. Sie sind beim orthoaxialen Schereffekt definitionsgemäss mit den Elektrodenflächen identisch und stehen beim Transversaleffekt zu letzteren senkrecht.

Figur 2 zeigt, wie das bereits um die X-Achse gedrehte Kristallelement (11) durch eine zweite Rotation bezüglich der transformierten Y'-Achse um den Winkel $\beta$ in das nunmehr zu allen kristallographischen Hauptachsen schief stehende Kristallelement (12) übergeht. Man erhält die folgenden, für alle sechs erwähnten Kristallklassen mit rein synaxialem Scherpiezoeffekt gültigen Formeln für das zuerst um die Achse X, dann um Y' rotierte Kristallelement (12) :

$$d''_{11} = (d_{14} + d_{25} + d_{36}) \cdot \cos \alpha \cdot \sin \alpha \cdot \cos \beta \cdot \sin^2\beta$$
$$d''_{12} = d_{14} \cdot \cos \alpha \cdot \sin \alpha \cdot \cos \beta$$
$$d''_{13} = -d_{14} \cdot \cos \alpha \cdot \sin \alpha \cdot \cos^3\beta + (d_{25} + d_{36}) \cos \alpha \cdot \sin \alpha \cdot \cos \beta \cdot \sin^2\beta$$
$$d''_{14} = d_{14} \cdot (\cos^2 \alpha - \sin^2) \cdot \cos^2\beta - (d_{36} \cdot \cos^2\alpha - d_{25}\sin^2\alpha) \sin^2\beta$$
$$d''_{15} = 2 \cdot d_{14} \cdot \cos \alpha \cdot \sin \alpha \cdot \cos^2\beta \cdot \sin \beta - (d_{25} + d_{36}) \cos \alpha \cdot \sin \alpha \cdot (\sin \beta - 2 \cos^2\beta \cdot \sin \beta)$$
$$d''_{16} = (d_{25} \cdot \sin^2\alpha - d_{14}(\cos^2\alpha - \sin^2\alpha) - d_{36} \cdot \cos^2\alpha) \cos \beta \cdot \sin \beta$$
$$d''_{21} = (d_{36} \cdot \sin^2\alpha - d_{25}\cos^2\alpha) \cdot \cos \beta \cdot \sin \beta$$
$$d''_{22} = 0$$
$$d''_{23} = (d_{25} \cdot \cos^2\alpha - d_{36} \cdot \sin^2\alpha) \cdot \cos \beta \cdot \sin \beta$$
$$d''_{24} = (d_{26} + d_{36}) \cos \alpha \cdot \sin \alpha \cdot \sin \beta$$
$$d''_{25} = (d_{25} \cdot \cos^2\alpha - d_{36} \cdot \sin^2\alpha) (\cos^2\beta - \sin^2\beta)$$
$$d''_{26} = (d_{25} + d_{36}) \cos \alpha \cdot \sin \alpha \cdot \cos \beta$$
$$d''_{31} = (d_{25} + d_{36}) \cos \alpha \cdot \sin \alpha \cdot \cos^2\beta \cdot \sin \beta - d_{14} \cdot \cos \alpha \cdot \sin \alpha \cdot \sin^3\beta$$
$$d''_{32} = d_{14} \cdot \cos \alpha \cdot \sin \alpha \cdot \sin \beta$$
$$d''_{33} = -(d_{14} + d_{25} + d_{36}) \cos \alpha \cdot \sin \alpha \cdot \cos^2\beta \cdot \sin \beta$$
$$d''_{34} = (d_{14}(\cos^2\alpha - \sin^2\alpha) - d_{25} \cdot \sin^2\alpha + d_{36} \cdot \cos^2\alpha) \cdot \cos \beta \cdot \sin \beta$$
$$d''_{35} = (d_{25} + d_{36}) \cos \alpha \cdot \sin \alpha \cdot (2 \cos \beta \cdot \sin^2\beta - \cos \beta) + 2 \cdot d_{14} \cdot \cos \alpha \cdot \sin \alpha \cdot \cos \beta \cdot \sin^2\beta$$
$$d''_{36} = d_{14} \cdot (\sin^2\alpha - \cos^2\alpha) \cdot \sin^2\beta - (d_{36} \cdot \cos^2\alpha - d_{25} \cdot \sin^2\alpha) \cdot \cos^2\beta$$

Eine Analyse dieser Gleichungen lässt leicht erkennen, dass die piezoelektrische Empfindlichkeit bei einem kubisch-polaren Kristall dann Maximalwerte erreicht, wenn die Krafteinleitungsflächen unter bestimmten Winkeln zu den Kristallhauptachsen liegen. Die Elektrodenflächen stehen definitionsgemäss senkrecht auf der Krafteinleitungsrichtung. Man kann damit die Schnittwinkel $\alpha'$, $\beta'$, $\gamma' = \beta'$ der Elektrodenflächen bezüglich der kristallographischen Hauptachsen X, Y, Z mittels einer elementaren trigonometrischen Umformung auch darstellen durch

$$\alpha' = \text{arc sin } \sqrt{p}$$

$$\beta' = \pm 1/2 \text{ arc cos } p$$

worin der Parameter p die Werte = 1 für den transversalen und 0 für den orthoaxialen Piezoeffekt hat. Damit sind für kubisch polare Kristalle sämtliche Orientierungen maximaler piezoelektrischer Empfindlichkeit festgelegt, denn aus der kubischen Symmetrie folgt zwangsläufig die Aequivalenz bei zyklischer Vertauschung der Orientierungswinkel.

Als Ausführungsbeispiel sei ein piezoelektrischer Kraft-, Druck- und Beschleunigungsaufnehmer beschrieben, der aus Wismutgermaniumoxid besteht. Dieses Material lässt sich in Form grosser Einkristalle nach dem Czochralski-Verfahren aus der Schmelze züchten. Dabei kann die Lage einer

**0 025 523**

kristallographischen Achse bereits durch den Keimling festgelegt werden. Da für piezoelektrische Messwandler die Anforderungen an die Orientierungspräzision relativ hoch sind, ist es zweckmässig, die genaue Achsenlage röntgenographisch zu bestimmen. Bei der praktischen Herstellung von Kristallelementen sind allerdings gewisse Orientierungstoleranzen unvermeidlich. Je nach den Anforderungen können Kristallelemente Verwendung finden, bei denen die Orientierung der Elektrodenflächen innerhalb eines Winkelbereiches von ± 15°, insbesondere von ± 10° und vorzugsweise von ± 5° mit der idealen Kristallebene übereinstimmt. Die piezoelektrischen Koeffizienten lassen sich dann leicht aus der Materialkonstante von Wismutgermaniumoxid berechnen, also dem Piezokoeffizienten $d_{14} = 3,88 \cdot 10^{-11} AsN^{-1}$.

Die piezoelektrischen Koeffizienten haben die Werte

$$d''_{11} = - d''_{12} = - 15,8 \ pC/N$$
$$d''_{15} = d''_{24} = + 22,4 \ pC/N$$
$$d''_{26} = + 31,7 \ pC/N$$
$$d''_{31} = d''_{32} = + 11,2 \ pC/N$$

Der erfindungsgemässe Messwandler aus Wismutgermaniumoxid bietet gegenüber einem konventionellen Quarz den Vorteil einer um den Faktor 9,7 mal höheren Empfindlichkeit bei Ladungsverstärkung.

Wismutgermaniumoxid hat zudem eine um den Faktor 8,7 mal höhere Dielektrizitätskonstante als Quarz. Dadurch bietet ein erfindungsgemässe Miniaturaufnehmern mit integrierten Impedanzwandler-Vorverstärkern zusätzliche Vorteile, wenn die Nebenschlusskapazitäten in der Grössenordnung der Kristallkapazität liegen. Ausserdem kann Wismutgermaniumoxid bei höheren Temperaturen eingesetzt werden, denn im Gegensatz zu Quarzkristallen neigt es nicht zur Verzwillingung und zu Kristallgitterumwandlungen. Es hat auch keinen Curiepunkt wie ferroelektrische Keramiken.

Die Formgebung eines erfindungsgemässen Kristallelementes braucht selbstverständlich nicht der in Figur 2 zur besseren Veranschaulichung der Achsenlagen gezeichneten Quaderform zu entsprechen. Da ja alle Orientierungsformeln von den geometrischen Abmessungen unabhängig sind, hat zum Beispiel eine Abrundung der Ecken keinen Einfluss auf die Piezoelektrizität. In Kraft-, Druck- und Beschleunigungsaufnehmern sind beispielsweise je nach Konstruktion dünne Kreisscheiben mit Isolierfasen oder auch Lochscheiben besonders zweckmässig.

In der Praxis werden die Krafteinleitungsflächen vorzugsweise plan parallel bearbeitet. Die Elektrodenflächen werden meist metallisiert, beispielsweise durch Hochvakuumbedampfung mit Gold oder durch Kathodenzerstäubung von Tantal-Platin.

Das erläuterte Beispiel ist nicht als eine Einschränkung der Anwendungsmöglichkeiten der Erfindung zu verstehen, die abgeleiteten Formeln zeigen vielmehr, dass gemäss der gegebenen technischen Lehre piezoelektrische Transversal- und orthoaxiale Schermesswandler in Schnittorientierungen maximaler Empfindlichkeit hergestellt werden können, aus jedem Material, das die genannten kristallographischen Symmetriebedingungen erfüllt.

**Patentansprüche**

1. Piezoelektrische Kraft-, Druck- und Beschleunigungsmesswandler, bestehend aus einem kubisch-polaren Einkristall, gekennzeichnet durch Elektrodenflächen, deren Orientierung innerhalb eines Winkelbereiches von ± 15° übereinstimmt mit einer Kristallebene, deren Schnittwinkel $\alpha'$ mit einer kristallographischen Hauptachse definiert ist durch

$$\alpha' = arc \ sin \sqrt{p}$$

und welche die beiden anderen Hauptachsen schneidet unter den Winkeln von

$$\beta' = \pm 1/2 \ arc \ cos \ p$$

worin p = 0 für den piezoelektrischen orthoaxialen Schereffekt und p = 1 für den transversalen Piezoeffekt, und durch planparallele Krafteinleitungsflächen, welche für den Schereffekt mit den Elektrodenflächen zusammenfallen und für den Transversaleffekt in senkrecht auf den Elektrodenflächen stehenden, zur Elementarzelle des Kristalls diagonalen Ebenen verlaufen.

2. Piezoelektrischer Wandler nach Anspruch 1, dadurch gekennzeichnet, dass die Orientierung der Elektrodenflächen innerhalb eines Winkelbereiches von ± 10° mit der Kristallebene übereinstimmt, die die kristallographischen Hauptachsen unter den Winkeln $\alpha'$ und $\beta'$ schneidet.

3. Piezoelektrischer Wandler nach Anspruch 2, dadurch gekennzeichnet, dass die Orientierung der Elektrodenflächen innerhalb eines Winkelbereiches von ± 5° übereinstimmt mit der Kristallebene, die die kristallographischen Hauptachsen unter den Winkeln $\alpha'$ und $\beta'$ schneidet.

4. Piezoelektrischer Wandler nach Anspruch 3, dadurch gekennzeichnet, dass die Elektrodenflächen in der Kristallebene liegen, die die kristallographischen Hauptachsen unter den Winkeln $\alpha'$ und $\beta'$

schneidet.

5. Piezoelektrischer Wandler nach einem der Ansprüche 1 bis 4 zur Umformung von Scherkräften in elektrische Signale mittels des orthoaxialen direkten Scherpiezoeffektes, dadurch gekennzeichnet, dass er von zwei planparallelen, zur Ladungsabnahme dienenden Krafteinleitungsflächen begrenzt ist, welche im wesentlichen parallel zur einen und unter 45° zu beiden anderen Hauptachsen verlaufen.

6. Piezoelektrischer Wandler nach einem der Ansprüche 1 bis 4 zur Umformung von Kräften, Drücken und Beschleunigungen in elektrische Signale mittels des transversalen direkten Piezoeffektes, dadurch gekennzeichnet, dass es von senkrecht zu einer Hauptachse verlaufenden Elektrodenflächen und von zwei planparallelen Krafteinleitungsflächen begrenzt wird, welch letztere unter 45° zu den beiden anderen Hauptachsen verlaufen.

7. Piezoelektrischer Wandler nach einem der Ansprüche 1 bis 4 zur Umformung mechanischer Grössen in elektrische bei hohen Temperaturen, dadurch gekennzeichnet, dass es aus einkristallinem Wismutgermaniumoxid besteht.

## Claims

1. A piezoelectric force and pressure transducer and accelerometer, consisting of a monocrystalline cubic-polar material, characterized by electrode faces, the orientation of which corresponds within an angular range of ± 15° to a crystal plane whose intersection angle $\alpha'$ with a crystallographic principal axis is defined by

$$\alpha' = \text{arc sin } \sqrt{p}$$

and which intersects the other two principal axes at angles of

$$\beta' = \pm 1/2 \text{ arc cos } p$$

wherein p = 0 for the piezoelectric orthoaxial shear effect, and p = 1 for the transverse piezoeffect ; and by plane-parallel force introduction surfaces which coincide with the electrode faces for shear effects, and which extend within planes perpendicular to the electrode faces and diagonal to the elementary cell of the crystal for the transverse piezoeffect.

2. A piezoelectric transducer according to claim 1, characterized in that the orientation of the electrode faces corresponds within an angular range of ± 10° to the crystal plane that intersects the crystallographic principal axes at the angles $\alpha'$ and $\beta'$.

3. A piezoelectric transducer according to claim 2, characterized in that the orientation of the electrode faces corresponds within an angular range of ± 5° to the crystal plane that intersects the crystallographic principal axes at the angles $\alpha'$ and $\beta'$.

4. A piezoelectric transducer according to claim 3, characterized in that the electrode faces lie within the crystal plane that intersects the crystallographic principal axes at the angles $\alpha'$ and $\beta'$.

5. A piezoelectric transducer according to one of the claims 1 to 4, for converting shear forces into electrical signals by the orthoaxial direct shear piezoeffect, characterized in that it is contoured by two plane-parallel force introduction surfaces serving for charge collection, which are essentially parallel to one crystallographic principal axis and extend at 45° to the other crystallographic principal axes.

6. A piezoelectric transducer according to one of the claims 1 to 4, for converting forces, pressures and accelerations into electric signals by the transverse direct piezoeffect, characterized in that it is contoured by electrode faces perpendicular to one crystallographic principal axis and by two plane-parallel force introduction surfaces, the latter of which extend at 45° to both other principal axes.

7. A piezoelectric transducer according to one of the claims 1 to 4, for converting mechanical quantities into electrical signals at high temperatures, characterized in that it consists of monocrystalline bismuth germanium oxide.

## Revendications

1. Transformateurs de mesure de forces, de pressions et d'accélérations et se composant d'un monocristal cubico-polaire, caractérisé par des surfaces d'électrodes dont l'orientation, dans les limites d'un domaine angulaire de ± 15°, coïncide avec un plan cristallin dont l'angle de coupe $\alpha'$ comportant un axe principal cristallographique est défini par

$$\alpha' = \text{arc sin } \sqrt{p}$$

et qui coupe les deux autres axes principaux selon l'angle

$$\beta' = \pm 1/2 \text{ arc cos } p$$

où p est égal à 0 pour l'effet de cisaillement orthoaxial piézo-électrique, et p est égal à 1 pour l'effet piézo-électrique transversal ; ainsi que par des surfaces d'introduction de force planes et parallèles, lesquelles coïncident, pour l'effet de cisaillement avec les surfaces d'électrodes et se développent, pour l'effet transversal, dans des plans diagonaux par rapport à la cellule élémentaire du cristal et situés perpendiculairement aux surfaces d'électrodes.

2. Transformateur piézo-électrique selon la revendication 1, caractérisé en ce que l'orientation des surfaces d'électrodes coïncide, dans les limites d'un domaine angulaire de $\pm 10^\circ$, avec le plan cristallin qui coupe les axes principaux cristallographiques selon les angles $\alpha'$ et $\beta'$.

3. Transformateur piézo-électrique selon la revendication 2, caractérisé en ce que l'orientation des surfaces d'électrodes coïncide, dans les limites d'un domaine angulaire de $\pm 5^\circ$, avec le plan cristallin qui coupe les axes principaux cristallographiques selon les angles $\alpha'$ et $\beta'$.

4. Transformateur piézo-électrique selon la revendication 3, caractérisé en ce que les surfaces d'électrodes se situent dans le plan cristallin qui coupe les axes principaux cristallographiques selon les angles $\alpha'$ et $\beta'$.

5. Transformateur piézo-électrique selon l'une quelconque des revendications 1 à 4, pour la transformation de forces de cisaillement en signaux électriques au moyen de l'effet de cisaillement piézo-électrique direct orthoaxial, caractérisé en ce qu'il est limité par deux surfaces d'introduction de forces planes et parallèles, servant à la diminution de la charge et se développant en substance parallèlement à un axe principal et selon 45° aux deux autres axes principaux.

6. Transformateur piézo-électrique l'une quelconque des revendications 1 à 4, pour la transformation de forces, de pressions et d'accélérations en signaux électriques au moyen de l'effet piézo-électrique direct transversal, caractérisé en ce qu'il est limité par des surfaces d'électrodes se développant perpendiculairement à un axe principal et par deux surfaces d'introduction de forces planes et parallèles et se développant selon un angle de 45° par rapport aux deux autres axes principaux.

7. Transformateur piézo-électrique selon l'une quelconque des revendications 1 à 4, pour la transformation de grandeurs mécaniques en signaux électriques à de hautes températures, caractérisé en ce qu'il se compose d'un oxyde de bismuth-germanium monocristallin.

Fig. 1

Fig. 2